# EUROPEAN PATENT APPLICATION

(11) **EP 2 330 870 A1**
(43) Date of publication of application: **08.06.2011**
(21) Application number: 09168897.8
(22) Date of filing: 28.08.2009
(51) Int. Cl.: H05B 37/02, H02M 3/156, H03K 7/08

(54) **Sampling trigger device and method thereof**

(71) Applicant: Freescale Semiconductor, Inc., Austin, TX 78735 (US); STMicroelectronics (Rousset) SAS, 13790 Rousset (FR)
(72) Inventor: Naspolini, Gustavo, 13087300, Campinas (BR); Scobie, James Andrew Collier, Helensburgh, G84 7SQ (GB); Kinowski, Paul, 81541 Munich (DE)
(74) Representative: Ferro, Frodo Nunes

(57) **Abstract**

A pulse-width-modulated (PWM) signal [303] controls a driver signal [304] applied to a load device, such as a lamp [106]. A feedback loop samples the driver signal and software at the device adjusts a pulse width of the PWM signal to ensure that a current level of the driver signal is maintained within specified limits. The feedback loop employs a sampling trigger signal [305] to control sampling of the driver signal. An asserting edge and successive negating edge of the sampling trigger signal are established based on comparison of a counter value to a single programmable time value. Accordingly, the sampling trigger signal will have a fixed pulse width.

## Description

### Field of the invention

The present disclosure relates generally to electronic devices and more particularly to sampling devices..

### Background of the invention

Pulse width modulation (PWM) control devices are sometimes employed to control power provided to an electronic device, such as an electric motor or a lamp. For example, in some devices the PWM control device generates a pulse-width-modulated signal, and provides the PWM signal to a driver module. The driver module generates a signal (e.g. a voltage signal or current signal) having a magnitude dependent on the width of the PWM signal, and provides the signal to the controlled electronic device. A feedback loop of the PWM control device can sample the signal provided to the electronic device and adjust the pulse width of PWM signal so that the magnitude of the signal remains within specified limits. Sampling of the signal can also be employed to detect faults in the electronic device. A sampling trigger module is sometimes employed to control when the signal provided to the electronic device is sampled. However, conventional sampling trigger modules can consume an undesirable amount of area.

### Summary of the invention

The present invention provides a method and an electronic device as described in the accompanying claims.

Specific embodiments of the invention are set forth in the dependent claims.

These and other aspects of the invention will be apparent from and elucidated with reference to the embodiments described hereinafter.

### Brief description of the drawings

Further details, aspects and embodiments of the invention will be described, by way of example only, with reference to the drawings. Elements in the figures are illustrated for simplicity and clarity and have not necessarily been drawn to scale.
FIG. 1 is a block diagram of a PWM control device in accordance with one embodiment of the present disclosure.
FIG. 2 is a block diagram of a particular embodiment of the PWM module and sampling trigger module of FIG. 1.
FIG. 3 is a diagram of a particular embodiment of signal waveforms associated with the PWM control device of FIG. 1.
FIG. 4 is a flow diagram of a method of providing a sample trigger signal in accordance with one embodiment of the present disclosure.

### Detailed description of the preferred embodiments

Because the illustrated embodiments of the present invention may for the most part, be implemented using electronic components and circuits known to those skilled in the art, details will not be explained in any greater extent than that considered necessary as illustrated below, for the understanding and appreciation of the underlying concepts of the present invention and in order not to obfuscate or distract from the teachings of the present invention.

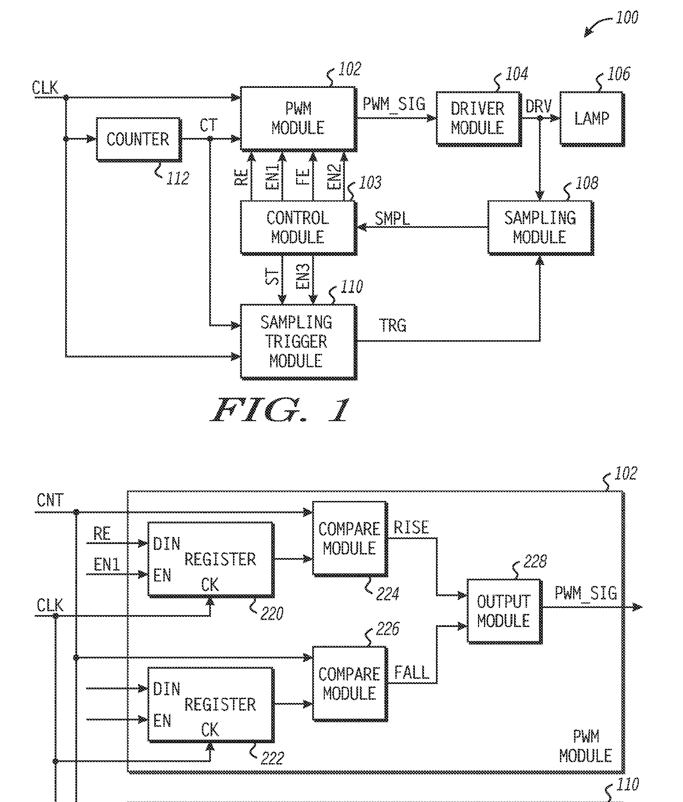

Figures 1-4 illustrate a device and methods for controlling a sampling trigger in accordance with one embodiment of the present disclosure. In the illustrated examples, a pulse-width-modulated (PWM) signal controls a driver signal applied to a load device, such as a lamp. A feedback loop of the device samples the driver signal and software at the device adjusts a pulse width of the PWM signal to ensure that a current level of the driver signal is maintained within specified limits. The feedback loop employs a sampling trigger signal to control sampling of the driver signal. In the illustrated embodiments, an asserting edge and successive negating edge of the sampling trigger signal are established based on comparison of a counter value to a single programmable time value. For example, an asserting edge (e.g. a rising edge) of the sampling trigger signal can be established based on the counter value matching the programmable time value. While the immediately succeeding negating edge (e.g. falling edge) is established in response to the counter value changing in response to a clock signal, so that the counter value no longer matches the programmable time value. Accordingly, the sampling trigger signal will have a fixed pulse width based on the width of one clock cycle. Because both the rising and negating edges are established based on a single counter value, the circuit area of the sampling trigger device is reduced relative to conventional sampling trigger devices. Further, programming of the time value to establish the edges of the sampling trigger signal is simplified.

FIG. 1 is a block diagram illustrating a device including a lamp control device 100 in accordance with one embodiment of the present disclosure. The lamp control device 100 can be implemented as one or more separate integrated circuits (ICs), such as in an application specific integrated circuit (ASIC). Alternately, the lamp control device 100 can be implemented in another device, such as, for example, a microprocessor or microcontroller implemented as a system-on-a-chip (SOC).

In the depicted example, the lamp control device 100 includes a PWM module 102, a driver module 104, and a lamp 106. Lamp 106 can be a light-generating device, such as a light emitting diode (LED) and the like. The PWM module 102 includes an output to provide a digital signal labeled "PWM_SIG." The PWM module 102 further includes a number of inputs to receive signals that establish the rising and falling edges of PWM_SIG. In particular, the PWM module 102 includes an input to receive a clock signal labeled "CLK", an input to receive a counter value labeled "CT", an input to receive an enable signal labeled "EN1", an input to receive a signal labeled "EN2", an input to receive a programmable value labeled "RE", and an input to receive a signal labeled "FE." As described further with respect to FIG. 2, the rising and falling edges of PWM_SIG are determined based on the relative values of CT, RE and FE respectively, while the signals EN1 and EN2 are load enable signals used to ensure that any changes in the values of RE and FE, respectively, occur deterministically with respect to the rising and falling edges of PWM_SIG. Thus, the signals CLK, CT, RE, FE, EN1, and EN2 control the pulse width of PWM_SIG.

In other embodiments, only one of the values of RE and FE is adjustable, while the other is maintained at a fixed amount. In such embodiments, only the enable signal associated with the adjustable value is employed. For example, in one embodiment the value of RE is maintained at a fixed amount, and the pulse width of PWM_SIG is adjusted by adjusting the value of FE. In this embodiment, only the signal EN2 is employed to ensure that changes in the value of FE occur deterministically.

The driver module 104 includes an input to receive PWM_SIG, and an output to provide an analog driver signal labeled "DRV." In the illustrated embodiment, it is assumed that the driver module 104 controls a current level of the signal DRV based on the pulse width of PWM_SIG. In an embodiment, the driver module 104 provides a relatively high amount of current via the signal DRV when PWM_SIG is asserted and provides a relatively low amount of current when the signal PWM_SIG is negated. Thus, for example, a relatively wider pulse width of PWM_SIG will cause the driver module 104 to provide relatively more current via signal DRV, while a relatively smaller pulse width will cause the driver module 104 to provide a smaller amount of current.

The lamp 106 is a lighting device, such as an LED, incandescent bulb, or other device to provide light. In particular, the lamp 106 is a load device that includes an input to receive the signal DRV. The relative brightness of the light emitted by the lamp 106 depends on the level of current provided by the signal DRV. Thus, because the signal DRV is based on the pulse width of the signal PWM_SIG, the brightness of lamp 106 can be controlled by adjusting the pulse width.

The lamp control device 100 employs a feedback loop to control the level of current supplied by the signal DRV, thereby ensuring the amount of power consumed by lamp 106 remains within established limits. The feedback loop includes a sampling module 108, a sampling trigger module 110, a counter 112, and a control module 103. The sampling module 108 includes an input to receive the signal DRV, and an input to receive a sampling trigger signal labeled "TRG." The sampling module 108 also includes an output to provide a sample (labeled SMPL) of the signal DRV in response to assertion of the signal TRG.

The sampling trigger module 110 includes an output to provide the signal TRG. In addition, the sampling trigger module 110 includes a number of inputs to receive signals that control assertion of the signal TRG. In particular, the sampling trigger module includes an input to receive the clock signal CLK, an input to receive programmable trigger timing information, labeled "ST", an input to receive the counter value CT, and an input to receive an enable signal labeled "EN3." The sampling trigger module 110 is configured to compare the timing information ST with the counter value CT and, in response to determining the values match, assert the signal TRG. In the embodiment of FIG. 1, it is assumed that when the values CT and ST do not match, the sampling trigger module 110 negates the signal TRG. As described further with respect to FIG. 2, the signal EN3 is employed to ensure that changes to the timing information ST occurs deterministically with respect to the clock signal CLK. In other embodiments the timing information ST is a fixed value that does not change during operation of the lamp control device 100. In such embodiments the signal EN3 is not employed.

The counter 112 includes an input to receive the clock signal CLK and an output to provide the counter value CT. The counter 112 is configured to adjust the value CT in response to edges of the clock signal CLK. In an embodiment, the counter 112 is configured to count the value CT down from a fixed or programmable top count value to a minimum value and, when the stored value reaches the minimum value, resets the stored value to the top count value. In another embodiment the counter 112 is a free running counter.

The control module 103 includes an input to receive the SMPL signal and outputs to provide the signals RE, FE, ST, EN1, EN2, and EN3. Based on the SMPL signal, the control module 103 controls the RE and FE signals to adjust the pulse width of PWM_SIG so that current provided via the signal DRV is maintained within specified limits. In an embodiment the adjustments to the RE and FE signals based on SMPL signal are determined by software executing at a processor device (not shown) of the lamp control device 100. The software can adjust the RE and FE signals by writing values to registers (not shown) of the control module 103. In addition, as explained further with respect to FIG. 2, the control module 103 controls the signal ST so that the sampling trigger module 110 triggers a sample when the signal DRV is expected to have achieved a nominal level relative to the assertions of PWM_SIG. Further, the control module 103 controls the signals EN1, EN2, and EN3 so that changes to the information provided via signals RE, FE, and ST, respectively, occur deterministically with respect to edges of the signal PWM_SIG.

In operation, the control module 103 provides timing information for the rising edge of PWM_SIG via the signal RE and provides timing information for the falling edge of PWM_SIG via the signal FE. The control module 103 also asserts the signals EN1 and EN2, respectively. In response to these signals, the PWM module 102 stores the timing information provided via signals RE and FE. For purposes of discussion, the timing information provided by signal RE is referred to as "rising edge information" while the timing information provided by signal FE is referred to as "falling edge information."

During operation, the PWM module 102 compares the value CT to the stored rising edge information and, in response to determining a match, asserts PWM_SIG. In addition, the PWM module 102 compares the value CT to the stored falling edge information and, in response to determining a match, negates PWM_SIG. The falling edge and rising edge thus determine the pulse width of PWM_SIG. Based on this pulse width, the driver module 104 sets the current level of the signal DRV.

In addition, the control module 103 provides timing information, referred to herein as "trigger information", to the sampling trigger module 110 via the signal ST and asserts the signal EN3. In response, the sampling trigger module 110 stores the trigger information. The sampling trigger module 110 compares the stored trigger information to the counter value provided via signal CT. When the trigger information does not match the counter value, the sampling trigger module 110 maintains the signal TRG in a negated state. When the trigger information matches the counter value, the sampling trigger module 110 maintains the signal TRG in an asserted state. Thus, because the counter 112 changes the counter value in response to each rising edge of the signal CLK, the signal TRG will be asserted for approximately one clock cycle in response to determining the trigger information matches the counter value.

In response to assertion of the signal TRG, the sampling module 108 takes a sample of the signal DRV and provides the sample via the signal SMPL. The signal SMPL thus represents the level of current of signal DRV when signal TRG is asserted. The control module 103 compares the indicated level of current to a threshold current level and adjusts the rising edge information and falling edge information accordingly. For example, in response to determining the level of current is less than the threshold level, the control module 103 adjusts the rising edge information and falling edge information to increase the pulse width of PWM_SIG. In response to determining the level of current is greater than the specified level, the control module 103 adjusts the rising edge information and falling edge information to reduce the pulse width of PWM_SIG. The control module 103 thus maintains the level of current provided by signal DRV within defined limits.

It will be appreciated that a change in the pulse width of PWM_SIG can cause a transient response in the signal DRV. Further, if a sample were taken by the sampling module 108 during such a transient response, the feedback loop could undesirably adjust the pulse-width of PWM_SIG. Accordingly, as the control module 103 adjusts the pulse width of PWM_SIG, it can also adjust the trigger information to ensure that samples of the signal DRV are taken at a time sufficiently remote from the transient response so that efficient operation of the feedback loop is maintained. In an embodiment, the signal ST is not adjusted after initial activation of the lamp 106, so that sampling occurs at a substantially fixed point after each rising edge of the signal PWM_SIG.

It will further be appreciated that, because the timing of both the rising edge and falling edge of the sample trigger TRG is based upon a single value provided by signal ST, the design and implementation of the control module 103 and any associated software is simplified relative to conventional devices. For example, some conventional lamp control devices employ a sampling trigger module that requires timing information to establish the rising edge of the sampling trigger and separate and distinct timing information to establish the falling edge. Thus, for these devices, the control module must determine new timing information for the rising edge and new timing information for the falling edge of the sampling trigger signal each time the desired sample time is adjusted. In contrast, the control module 103 only needs to determine a single trigger information value in order to adjust the sample timing. The control module 103 and associated software is therefore simplified relative to conventional devices. Further, the sampling trigger module 110 is also simplified relative to conventional devices, so that the module can consume relatively less area of an integrated circuit.

FIG. 2 illustrates a block diagram of a particular embodiment of the sampling trigger module 110 and the PWM module 102. In the illustrated example, the PWM module 102 includes registers 220 and 222 to store rising edge information and falling edge information. In particular, register 220 includes an input labeled "DIN" to receive rising edge information via the signal RE, an input labeled "EN" to receive the signal EN1, and an input labeled "CK" to receive the clock signal CLK. The register 220 is configured to store rising edge information received via the signal RE in response to a rising edge of the signal CLK when the signal EN1 is asserted. The register 220 also includes an output configured to provide the stored rising edge information value. Similarly, the register 222 includes an input labeled "DIN" to receive falling edge information via the signal FE, an input labeled "EN" to receive the signal EN2, and an input labeled "CK" to receive the clock signal CLK. The register 222 is configured to store falling edge information received via the signal FE in response to a rising edge of the signal CLK when the signal EN2 is asserted. The register 222 also includes an output configured to provide the stored falling edge information value.

The PWM module 102 also includes compare modules 224 and 226. Compare module 224 includes an input connected to the output of the register 220 and an input to receive the counter value provided by signal CNT. The compare module 224 further includes an output to provide a signal labeled "RISE." Compare module 224 is configured to assert the signal RISE in response to determining a match between the rising edge information stored at the register 220 and the counter value provided by the signal CNT. Similarly, compare module 226 includes an input connected to the output of the register 222 and an input to receive the counter value provided by signal CNT. The compare module 226 further includes an output to provide a signal labeled "FALL." Compare module 224 is configured to assert the signal FALL in response to determining a match between the falling edge information stored at the register 222 and the counter value provided by the signal CNT.

The PWM module 102 further includes an output module 228 having an input to receive the signal RISE, an input to receive the signal FALL, and an output to provide the signal PWM_SIG. The output module 228 is configured to assert PWM_SIG in response to assertion of the signal RISE and negate the signal PWM_SIG in response to assertion of the signal FALL.

The sampling trigger module 110 includes a register 230 to store trigger information. In particular, register 230 includes an input labeled "DIN" to receive trigger information via the signal ST, an input labeled "EN" to receive the signal EN3, and an input labeled "CK" to receive the clock signal CLK. The register 230 is configured to store trigger information received via the signal ST in response to a rising edge of the signal CLK when the signal EN3 is asserted. The register 230 also includes an output configured to provide the stored trigger information.

The sampling trigger module 110 also includes a compare module 232 having an input connected to the output of the register 230 and an input to receive the counter value provided by signal CNT. The compare module 232 further includes an output to provide the trigger signal TRG. Compare module 232 is configured to assert the signal TRG in response to the received trigger information matching the received counter value and negate the signal TRG when the received trigger information is different from the received counter value. Thus, the sampling trigger module 110 provides an asserted signal for the clock cycle when the counter value matches the trigger value, and provides a negated signal when the counter value differs from the trigger value.

In the illustrated example of FIG. 2, the sampling trigger module 110 is similar to the PWM module 102 in that it asserts the TRG signal in response to a stored value matching the counter value. However, the sampling trigger module does not independently control a rising edge and corresponding falling edge of the TRG signal. Instead, the timing of the rising edge and corresponding falling edge of the TRG signal are both based on the trigger information stored at the register 230. In contrast, some conventional devices employ a device similar to the PWM module 102 in order to generate the sampling trigger. Accordingly, in such conventional devices, a rising edge and corresponding falling edge are independently controlled based on separate rising edge information and falling edge information. Because such conventional devices typically employ separate registers and logic to generate the rising and falling edges, the devices consume more area than the sampling trigger module 110.

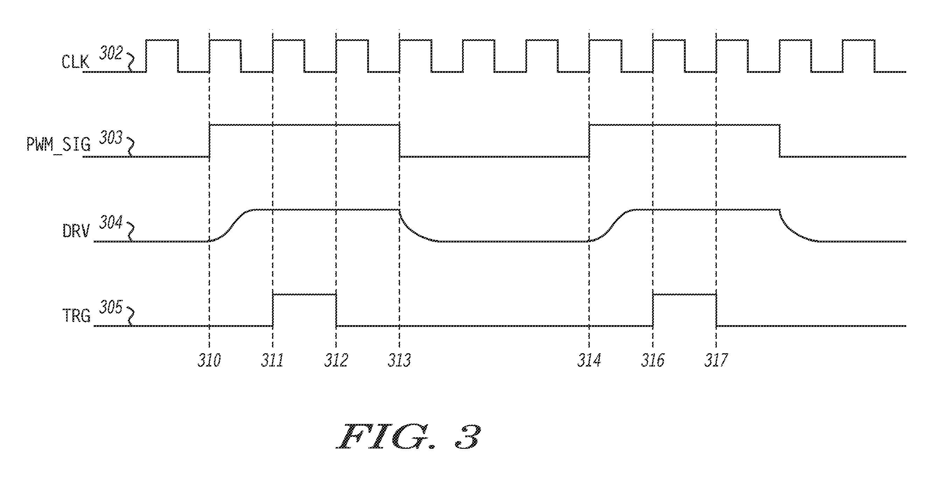

The operation of the lamp control device 100 can be better understood with reference to FIG. 3, which illustrates signal waveforms in accordance with one embodiment of the present disclosure. In particular, signal waveform 302 represents the waveform of the clock signal CLK, signal waveform 303 represents the waveform of the signal PWM_SIG, signal waveform 304 represents the current level provided via the signal DRV and signal waveform 305 represents the waveform of the sample trigger signal TRG.

In the embodiment of FIG. 3, at time 310 the clock signal CLK experiences a rising edge. For purposes of discussion, it is assumed that this rising edge causes adjustment of the counter value stored at counter 112, such that the counter value matches the rising edge information stored at the register 220 (FIG. 2). Accordingly, at time 310 the PWM module 102 asserts PWM_SIG. As illustrated by waveform 304, this causes an increase in the current provided by the signal DRV from a relatively low level to a relatively high level.

At time 311, the clock signal CLK experiences another rising edge. For purposes of discussion, it is assumed that this rising edge causes adjustment of the counter value stored at counter 112, such that the counter value matches the trigger information stored at the register 230 (FIG. 2). Accordingly, at time 311 the sampling trigger module 110 asserts the trigger signal TRG. This causes the sampling module 108 to take a sample of the signal DRV. As illustrated in FIG. 3, the assertion of the signal TRG is timed so that it is remote from the transition in the signal DRV at time 310. This increases the likelihood that the signal DRV has reached a quiescent level when the sample is taken, thereby improving the reliability of the operation of lamp control device 100.

At time 312, the clock signal CLK experiences another rising edge. For purposes of discussion, it is assumed that this rising edge causes adjustment of the counter value stored at counter 112, such that the counter value does not match the trigger information stored at the register 230 (FIG. 2). Accordingly, at time 311 the sampling trigger module 110 negates the trigger signal TRG. Thus, as illustrated in FIG. 3, the pulse width associated with the signal TRG is approximately the same as one clock cycle associated with the clock signal CLK.

At time 313 the clock signal CLK experiences another rising edge. For purposes of discussion, it is assumed that this rising edge causes adjustment of the counter value stored at counter 112, such that the counter value matches the falling edge information stored at the register 222. Accordingly, at time 313 the PWM module 102 negates PWM_SIG. Thus, in the illustrated example of FIG. 3, the assertion of the signal TRG is taken so that the resulting sample is taken while PWM_SIG is asserted.

At time 314, a rising edge of the CLK signal triggers an assertion of the PWM signal and an increase in the current provided by the signal DRV. Accordingly, at time 316, a rising edge of the signal CLK causes assertion of the signal TRG, causing another sample to be taken. At time 317, the rising edge of the signal CLK causes negation of the signal TRG. Accordingly, as illustrated in FIG. 3, the signal TRG is asserted so that a sample is taken when the signal DRV is at a relatively high level, and sufficiently remote from transitions in the signal DRV so that the signal is quiescent. This improves the reliability of the operation of lamp control device 100.

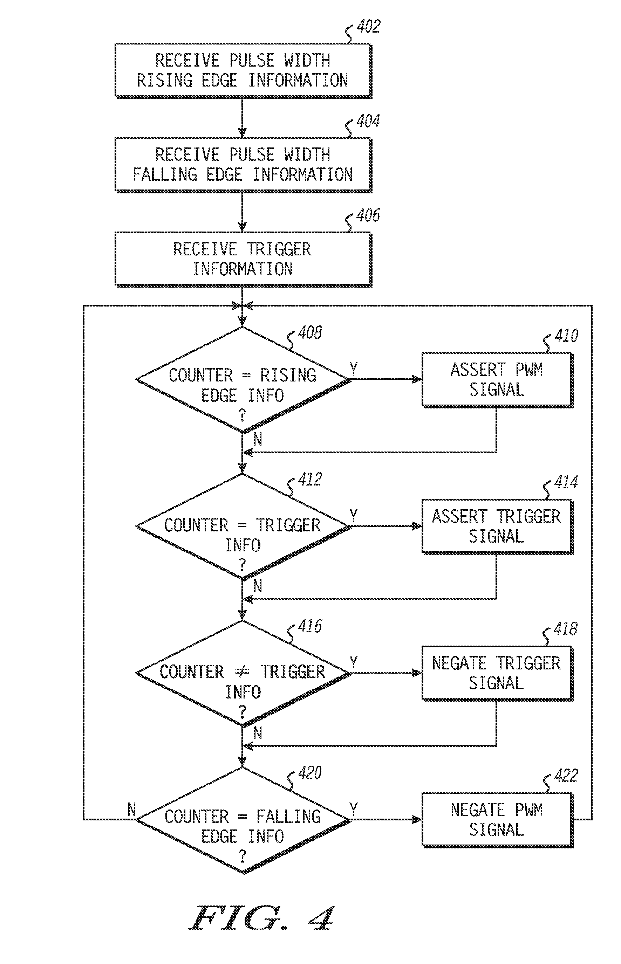

FIG. 4 illustrates a flow diagram of a method of providing a sample trigger signal in accordance with one embodiment of the present disclosure. At block 402, the PWM module 102 receives rising edge information for PWM_SIG vial signal RE. At block 406, the PWM module 102 receives falling edge information for PWM_SIG vial signal FE. Further, at block 406, the sampling trigger module 110 receives trigger information via the signal ST.

At block 408, the PWM module 102 determines if the value at counter 112 is equal to the received rising edge information. If not, the method flow moves to block 412. If so, the method flow moves to block 410 and the PWM module 102 asserts PWM_SIG. The method flow proceeds to block 412.

At block 412, the sampling trigger module 110 determines if the value at counter 112 is equal to the received trigger information. If not, the method flow moves to block 416. If so, the method flow moves to block 414 and the sampling trigger module 110 asserts the signal TRG. The method flow proceeds to block 416.

At block 416, the sampling trigger module 110 determines if the value at counter 112 is different than the received trigger information. If not, the method flow moves to block 420. If so, the method flow moves to block 418 and the sampling trigger module 110 negates the signal TRG. The method flow proceeds to block 420.

At block 20, the PWM module 102 determines if the value at counter 112 is equal to the received falling edge information. If not, the method flow returns to block 408. If so, the method flow moves to block 422 and the PWM module 102 negates PWM_SIG. The method flow returns to block 408.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. Accordingly, the present disclosure is not intended to be limited to the specific examples described above and it will be evident that various modifications and changes may be made therein without departing from the broader spirit and scope of the invention as set forth in the appended claims.

For example, in some embodiments, the lamp control device 100 does not include a driver module 104, and the lamp 106 is driven directly by the signal PWM_SIG or another signal based thereon. In such embodiments, the sampling module 108 can sample the signal PWM_SIG directly. Further, in some embodiments the driver module 104 or the lamp 106 can be controlled based on the voltage of the signal DRV or the signal PWM_SIG, rather than the current level of the signal.

In addition, in some embodiments the counter 112 may employ a prescaler such that the counter is adjusted at a different rate from the clock signal CLK. In such an embodiment, the sampling trigger module 110 can employ additional logic at the output of the compare module 232 which ensures that when the signal TRG is in an asserted state, it is negated one cycle of the signal CLK after its assertion.

However, other modifications, variations and alternatives are also possible. The specifications and drawings are, accordingly, to be regarded in an illustrative rather than in a restrictive sense.

In this document, the terms "asserted" and "negated" and "asserting" and "negating" refer to relative logic levels of a particular signal, and do not refer to a particular signal level. Thus, for example, a signal in an asserted state could have a relatively lower current or voltage level relative to the signal in a negated state. Another signal in an asserted state could have a relatively higher current or voltage level relative to the signal in a negated state. Further, different signals could have different relative levels in their respective asserted and negated states. Thus, for example, one signal in an asserted state could have a relatively lower current or voltage level relative to the signal in a negated state while a different signal in an asserted state could have a relatively higher current or voltage level relative to the signal in a negated state.

In this document, relational terms such as "first" and "second", and the like, may be used solely to distinguish one entity or action from another entity or action without necessarily requiring or implying any actual such relationship or order between such entities or actions. The term "another", as used herein, is defined as at least a second or more. The terms "including", "having", or any variation thereof, as used herein, are defined as comprising. The term "coupled", as used herein with reference to electro-optical technology, is defined as connected, although not necessarily directly, and not necessarily mechanically.

In the claims, any reference signs placed between parentheses shall not be construed as limiting the claim. The word 'comprising' does not exclude the presence of other elements or steps then those listed in a claim. Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. The mere fact that certain measures are recited in mutually different claims does not indicate that a combination of these measures cannot be used to advantage.

## Claims

1. A method for controlling a sampling trigger, comprising:
providing an asserting edge of a pulse-width modulated signal (303) based on first information;
providing a negating edge of the pulse-width modulated signal (303) based on second information;
driving a first signal based on the pulse-width modulated signal (304);
providing an asserting edge and a negating edge of a sample trigger signal based on third information (305); and
sampling (108) the first signal in response to a first edge of the sample trigger signal.

2. The method of claim 1, wherein:
providing the asserting edge of the pulse-width modulated signal comprises providing the asserting edge in response to a first edge of a clock signal (302); and
providing the negating edge of the sample trigger signal in response to a second edge of the clock signal (302); and
providing the negating edge of the sample trigger signal in response to a third edge of the clock signal (302).

3. The method of claim 2, wherein the amount of time between the asserting edge of the sample trigger signal and the negating edge of the sample trigger signal is substantially equal to the amount of time between the second edge and the third edge of the clock signal.

4. The method of claim 1, 2, or 3, further comprising:
adjusting a pulse-width of the pulse width modulated signal (303) based on sampling the first signal.

5. The method of claim 1, 2, 3, or 4, further comprising:
driving a light source based on the first signal.

6. The method of claim 1, 2, 3, 4, or 5, wherein providing the asserting edge and the negating edge of the sample trigger signal comprises:
providing the asserting edge of the sample trigger signal in response to determining a value stored at a counter matches the third information (414); and
providing the negating edge of the sample trigger signal (418) in response to determining, after providing the asserting edge, that the value stored at the counter does not match the third information.

7. The method of claim 1, 2, 3, 4, 5, or 6, wherein:
providing the asserting edge of the pulse-width modulated signal comprises providing the asserting edge in response to determining the value stored at the counter matches the first information (410); and
providing the negating edge of the pulse-width modulated signal comprises providing the negating edge in response to determining the value stored at the counter matches the second information (418).

8. The method of claim 1, 2, 3, 4, 5, 6, or 7, further comprising:
providing a first enable signal to load the first information, a second enable signal to load the second information, and a third enable signal to load the third information (103).

9. A electronic device, comprising:
a pulse-width signal generation module (102) comprising an input to receive first information, an input to receive second information, and an output to provide a pulse width modulated signal having a asserting edge based on the first information and a negating edge based on the second information;
a sample trigger module (110) comprising an input to receive third information and an output to provide a sample trigger signal having a asserting edge based on the third information and a negating edge based on the third information;
a sampling module (108) comprising a first input coupled to the output of the driver module, a second input coupled to the output of the sample trigger module, and an output to provide a sample of a signal at the first input in response to assertion of the sample trigger signal.

10. The device of claim 9, further comprising:
a counter (112) comprising an input to receive a clock signal and an output to provide information indicative of a value stored at a counter, the counter configured to adjust the value based on the clock signal.

11. The device of claim 10, wherein the sample trigger module comprises:
a first register (230) comprising an input to receive the third information and an output;
a first compare module (232) comprising a first input coupled to the output of the first register, a second input coupled to the output of the counter, and an output configured to assert the sample trigger signal in response to the value stored at the counter matching the value stored at the first register and negate the sample trigger signal in response to the value stored at the counter not matching the value stored at the first register.

12. The device of claim 9, 10 or 11, wherein the pulse-width signal generation module comprises:
a second register (220) comprising an input to receive the first information and an output;
a second compare module (224) comprising a first input coupled to the output of the second register, a second input coupled to the output of the counter, and an output configured to assert the pulse-width modulated signal in response to the value stored at the counter matching the value stored at the second register;
a third register comprising (222) an input to receive the second information and an output; and
a third compare module (226) comprising a first input coupled to the output of the third register, a second input coupled to the output of the counter, and an output configured to negate the pulse-width modulated signal in response to the value stored at the counter matching the value stored at the third register.

13. The device of claim 9, 10, 11, or 12, further comprising:
a control module (103) comprising an input coupled to the output of the sampling module and an output coupled to the pulse-width signal generation module, the control module configured to adjust the pulse width of the pulse-width modulate signal based on the sample.

14. The device of claim 9, 10, 11, 12, or 13, further comprising:
a light source (106) comprising an input coupled to the output of the pulse-width signal generation module.

15. The device of claim 9, 10, 11, 12, 13 or 14, further comprising:
a driver module (104) comprising an input coupled to the output of the pulse-width generation module and an output coupled to the input of the sampling module, the driver module to provide a driver signal based on a pulse width of the pulse-width modulated signal.
